# EUROPEAN PATENT SPECIFICATION

(11) **EP 3 093 874 B1**
(45) Date of publication and mention of the grant of the patent: **03.04.2019**
(21) Application number: 14868723.9
(22) Date of filing: 20.02.2014
(51) Int. Cl.: C23C 16/08, C23C 16/52, H01L 21/28, H01L 21/3205, H01L 21/285, H01L 21/768, H01L 29/66

(54) **TUNGSTEN LAYER DEPOSITING METHOD CAPABLE OF IMPROVING ADHESIVE PERFORMANCE AND FILLING PERFORMANCE**
VERFAHREN ZUR ABSCHEIDUNG VON WOLFRAMSCHICHTEN MIT VERBESSERTER ADHÄSION UND VERBESSERTEM FÜLLVERHALTEN
PROCÉDÉ DE DÉPÔT DE COUCHE DE TUNGSTÈNE APTE À AMÉLIORER L'EFFICACITÉ D'ADHÉSION ET L'EFFICACITÉ DE REMPLISSAGE

(30) Priority: 03.01.2014 CN 201410003202
(43) Date of publication of application: 16.11.2016
(73) Proprietor: Institute Of Microelectronics, Chinese Academy Of Sciences, Beijing 100029 (CN)
(72) Inventor: XU, Qiang, Beijing 100029 (CN); ZHAO, Chao, B-3010 (BE); LUO, Jun, Beijing 100029 (CN); WANG, Guilei, Beijing 100029 (CN); YANG, Tao, Beijing 100029 (CN); LI, Junfeng, Beijing 100029 (CN)
(74) Representative: Berggren Oy, Helsinki & Oulu
(86) International application number: PCT/CN2014/072304
(87) International publication number: WO 2015/100847

(56) References cited:
- CN-A- 1 436 876
- CN-A- 101 154 576
- CN-A- 101 447 427
- CN-A- 101 593 723
- US-A1- 2006 115 977
- US-A1- 2008 124 926
- US-A1- 2009 053 893
- US-B1- 6 635 965

## Description

### TECHNICAL FIELD

The present disclosure relates to the field of semiconductor manufacture, and more particularly, to a method of depositing a Tungsten (W) layer with improved adhesion and filling behavior.

### BACKGROUND

As the feature size of Complementary Metal-Oxide-Semiconductor (CMOS) devices is continuously scaling down, a thickness of gate oxide gradually approaches the atomic distance. Due to the tunneling effect, increased gate leakage current, reduced reliability and the like become non-negligible problems. Thus, the conventional gate dielectric material of SiO₂ can't meet the requirement of further scaling down of the CMOS devices. Beyond the 45nm node, it is necessary to replace SiO₂ with gate dielectrics with a high dielectric constant (high-K). On the other hand, since the conventional poly silicon gate is not compatible with the high-K material, which leads to problems such as increased threshold voltage (Vₜ), serious interfacial reaction during annealing, and so on, the poly silicon gate tends to be replaced with a metal gate so as to eliminate in nature such effects as gate depletion, boron penetration and the like which are inherent to the poly silicon gate.

There are two methods for implementing the high-K gate, one of which is a gate-first process and the other of which is a gate-last process. The difference between the gate-first process and the conventional SiO₂/poly silicon gate process is little. In the gate-first process, the gate dielectric and the metal gate are formed prior to the forming of drain and source. In contrast, in the gate-last process, a sacrificial gate, a sacrificial gate dielectric layer, source and drain and an interlayer dielectric layer are firstly formed, and then the sacrificial gate is removed and the gate is re-formed.

The gate-first process gradually becomes eliminated at present, because the material of the gate is affected by the annealing process of the source and drain at high temperature, which in turn constrains the choice of the gate material. On the other hand, in the gate-last process, the material of the gate needs not to undergo annealing at high temperature, so more kinds of materials can be used for the gate and intrinsic characteristics of the materials can be presented. At present, most companies employ the gate-last process to develop and manufacture a CMOS device with a feature size of 45nm or less.

In general, Aluminum (Al) or Tungsten (W) may be utilized for the gate electrode in the gate-last process. Intel earliest reported a chip process of 45nm by utilizing Al as the material for the gate electrode. Since a planarization process follows the process of filling the metal electrode and it is difficult to control the planarization process for Aluminum in large-scale production, the metal of Tungsten (W) becomes a candidate for the gate material by most companies.

In the gate-last process, the filling of the gate material is implemented after removing the sacrificial gate, and thus the requirement for the filling behavior of the gate material is very strict. Further, beyond the 22nm node, the space for gate filling become smaller. Thus, for the gate material of the metal Tungsten, the conventional Chemical Vapor Deposition (CVD) method can't meet the requirement of filling, and instead the Atomic Layer Deposition (ALD) process gradually becomes more popular. In view of the requirements of the sheet resistance and the filling behavior, ALD W manufactured by a B₂H₆ source is usually used for the metal gate.

However, since the B₂H₆ base ALD W film has poor adhesion, it is easy for such a film to crack in the subsequent metal planarization process and to delaminate from a barrier layer of TiN, which greatly influences the yield.

US 2006/115977 discloses a method of metallizing contact holes or vias with CVD tungsten. The method includes the deposition by ALD of a SiH₄ base W film and a B₂H₆ base W film as nucleation layers for the CVD tungsten fill.

US 2009/053893 discloses various tungsten deposition methods by vapor deposition including pre-soak processes.

### SUMMARY OF THE DISCLOSURE

In view of the problems mentioned above, the present disclosure aims to provide, among others, a method of depositing a Tungsten (W) layer with improved adhesion and filling behavior.

According to an aspect of the present disclosure, there is provided a method of depositing a Tungsten (W) layer according to claim 1. The method comprises pre-processing a substrate by depositing a SiH₄ base W film on a surface of the substrate, and depositing a B₂H₆ base W layer on the pre-processed surface.

The SiH₄ base W film may be formed on the surface of the substrate to a thickness of several atom layers.

The deposition of the SiH₄ base W film and that of the B₂H₆ base W layer are implemented in a single ALD process. The ALD process may comprise, for example, a reactive source gas soak operation, a reactive source gas introduction operation, and a main deposition operation. In this case, forming the SiH₄ base W film may comprise introducing a SiH₄ gas to a reactive cavity during the reactive source gas soak operation, and comprises introducing a SiH₄ gas and a WF₆ gas to the reactive cavity during the reactive source gas introduction operation. During the reactive source gas introduction operation, the SiH₄ gas and the WF₆ gas may be alternately introduced into the reactive cavity for several (for example, 2-10) cycles. Depositing the B₂H₆ base W layer comprises alternately introducing a B₂H₆ gas and a WF₆ gas into the reactive cavity for a number of cycles during the main deposition operation. The number of the cycles may depend on a thickness of the Tungsten layer to be deposited.

The substrate comprises a gate trench formed by a gate-last process, and the W film and the W layer fill into the gate trench to function as a gate electrode.

According to embodiments of the present disclosure, prior to depositing the B₂H₆ base W layer, the substrate is pre-processed by the SiH₄ gas so as to form the SiH₄ base W film with a thickness of several atom layers. On one hand, an excellent filling behavior of the B₂H₆ base W layer may be reserved; and on the other hand, adhesion may be improved by incorporating the SiH₄ base W film. In addition, the deposition of the B₂H₆ base W layer and that of the SiH₄ base W film may be implemented in a single ALD process. Thus, the yield can be increased and the window for filling may be extended.

### BRIEF DESCRIPTION OF THE DRAWINGS

The above and other objects, features and advantages of the present disclosure become more apparent from following descriptions of embodiments with reference to the accompanying drawings, in which:
Fig. 1 shows a flowchart of a method of depositing a W layer according to an embodiment of the present disclosure;
Fig. 2 shows a flowchart of an Atom Layer Deposition (ALD) process according to an embodiment of the present disclosure;
Fig. 3A and 3B are pictures which show a cross section view and a top view of a W layer manufactured according to an example method of the present disclosure, respectively; and
Fig. 4A and 4B are pictures which show a cross section view and a top view of a B₂H₆ base W layer manufactured according to a conventional method, respectively.

### DETAILED DESCRIPTION

Hereinafter, descriptions are given with reference to embodiments shown in the attached drawings. However, it is to be understood that these descriptions are illustrative and not intended to limit the present disclosure. Further, in the following, known structures and technologies are not described to avoid obscuring the present disclosure unnecessarily.

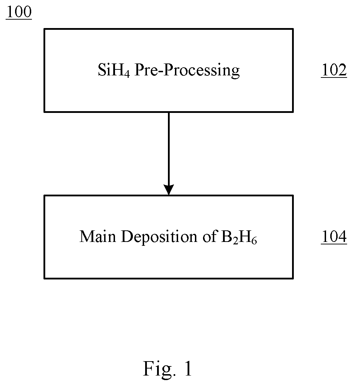

Fig. 1 shows a flowchart of a method of depositing a W layer according to an embodiment of the present disclosure. As shows in Fig. 1, the method 100 may comprise an operation 102 of pre-processing a surface where a Tungsten (W) layer is to be deposited by depositing a SiH₄ base W film on the surface.

For example, such a surface may comprise a surface of a substrate on which a device may be formed. The substrate may comprise various suitable substrates, such as a bulk semiconductor substrate, a Semiconductor On Insulator (SOI) substrate, and so on. In the following, the bulk silicon substrate is taken as an example, but the present disclosure is not limited thereto.

The substrate has a device manufactured by a gate-last process (or a part of thereof) formed thereon. For example, such a device may be manufactured as follows. In particular, a sacrificial gate stack including a sacrificial gate dielectric layer (e.g. SiO₂) and a sacrificial gate conductor (e.g. poly silicon) may be formed on the substrate. Halo implantation and extension implantation may be performed with the sacrificial gate stack as a mask. Then, a gate spacer of, e.g., nitride, may be formed on sidewalls of the sacrificial gate stack, and source/drain (S/D) implantation may be performed with the gate spacer and the sacrificial gate stack as a mask. A thermal treatment may be performed to activate implanted ions. Then, an interlayer dielectric layer of, e.g., oxide, may be deposited on the substrate, and a planarization process such as Chemical Mechanical Polishing (CMP) may be performed on the interlayer dielectric layer. The planarization process may stop on the gate spacer so as to expose the sacrificial gate stack. The sacrificial gate stack may be selectively removed so as to leave a gate trench at an inner side of the gate spacer. At last, an actual gate stack may be filled into the gate trench, for example, including a high-K gate dielectric layer of, e.g., HfO₂, and a metal gate conductor of, e.g., W. The method 100 may be applied for filling a W layer into the gate trench.

It is to be noted that the gate-last process is not limited to the above implementation and those skilled in the art can conceive various ways to implement the gate-last process.

The pre-processing comprises introducing a SiH₄ gas into a reactive cavity where the surface to be processed (in particular, the substrate carrying this surface) is located. As will be further illustrated in detail, the pre-processing may be incorporated into an Atom Layer Deposition (ALD) process. In this case, the reactive cavity may be a place where the ALD is to be performed. Such pre-processing may lead to a W film of several (e.g. less than 10) atom layers on the surface. The SiH₄ base W film helps to improve the adherence of the body of a W layer to be deposited subsequently (to, for example, an underlying TiN barrier layer).

After the pre-processing operation 102, the method 100 comprises an operation 104 of further depositing a B₂H₆ base W layer on the surface (in particular, on the SiH₄ base W film). For example, the B₂H₆ base W layer is deposited by alternately introducing a B₂H₆ gas and a WF₆ gas to the reactive cavity, and such a deposition is ALD. Since the growth rate for the B₂H₆ base W layer is relatively slow (e.g. about 3.1Å /cycle), the filling behavior is good.

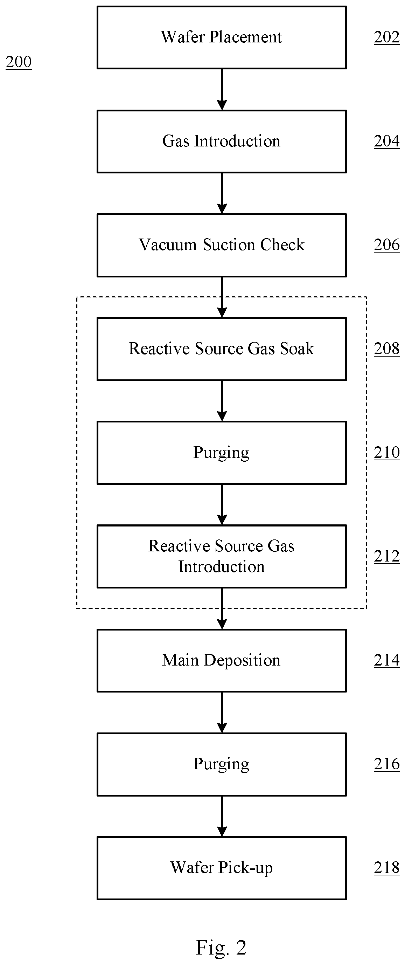

As mentioned above, the technique of the present disclosure is incorporated to the ALD process. Fig. 2 shows a general flowchart of an Atom Layer Deposition (ALD) process. The flow 200 comprises an operation 202 of positioning a wafer to be processed into a reactive cavity. In operation 204, an inert gas such as Ar may be introduced to the reactive cavity to keep a certain degree of vacuum within the reactive cavity. To ensure that the process smoothly goes on, in operation 206, it is checked whether the wafer is reliably fixed (e.g. by vacuum suction) to a reactive base. After the preparing operations mentioned above, formal deposition is started. Firstly, in a reactive source gas soak operation 208, a reactive source gas is introduced to the reactive cavity. In operation 210, an inert gas may be used for purging so as to remove the extra reactive source gas adsorbed on the surface of the wafer. Then, in a reactive source gas introduction operation 212, reactive source gases are introduced into the reactive cavity. Next, a main deposition operation 214 is performed. During the main deposition operation 214, reactive gases are alternately introduced into the reactive cavity (e.g. in case of depositing a B₂H₆ base W layer, a B₂H₆ gas and a WF₆ gas are alternately introduced). The reactive gases react within the reactive cavity to generate a thin film with a desired composition. During the procedure of introducing the reactive gases, an inert gas may be used for purging to remove the extra reactive gases. After depositing a thin film with a certain thickness, in operation 216, an inert gas may be further used for purging to take away the extra reactive gases in the reactive cavity. Finally, in operation 218, the wafer with the deposited thin film is removed from the reactive cavity.

According to a conventional technique, in case of utilizing the reactive gases of B₂H₆ and WF₆ to deposit the B₂H₆ base W layer, the B₂H₆ gas is usually introduced in the reactive source gas soak operation 208 and the B₂H₆ gas and the WF₆ gas are introduced in the reactive source gas introduction operation 212. On the contrary, according to an embodiment of the present disclosure, the SiH₄ gas is introduced in the operation 208 and the SiH₄ gas and the WF₆ gas are introduced in the operation 212. Such operations of reactive source gas soak and reactive source gas introduction lead to pre-processing on the surface and forming a SiH₄ base W film.

In the reactive source gas introduction operation 212, the SiH₄ gas and the WF₆ gas are alternately introduced. For example, when the SiH₄ gas is being introduced, the SiH₄ gas may be adsorbed to the surface of the wafer. Then, when the WF₆ is being introduced, WF₆ reacts with SiH₄ adsorbed to the surface of the wafer so as to form a W film on the surface of the wafer. Every time the SiH₄ and WF₆ gases are introduced, an inert gas may be used for purging to remove the extra reactive gases so that only a single layer or several layers of atoms are absorbed to the surface of the wafer. Thus, the reaction occurred on the surface of the wafer may be controlled in unit of an atom layer. The above mentioned operations may constitute a cycle. The SiH₄ gas and the WF₆ gas may be alternately introduced for several (e.g. 2-10) cycles to form a SiH₄ base W film with a thickness of several atom layers.

Likewise, in the main deposition operation 214, the B₂H₆ gas and the WF₆ gas are alternately introduced. Every time the B₂H₆ and WF₆ gases are introduced, an inert gas may be used for purging. A number of cycles (e.g. 250 cycles) may be performed to deposit a B₂H₆ base W layer with a desired thickness. The number of the cycles of the main deposition operation mainly depends on the thickness of the W layer to be deposited.

In the above description, particular process parameters for the respective steps in the ALD process are not illustrated. Those skilled in the art may set these process parameters as necessary according to particular designs and particular deposition tools. Furthermore, those skilled in the art may conceive various flows for the ALD process. For example, some steps may be omitted from or added to the flowchart 200 shown in Figure 2.

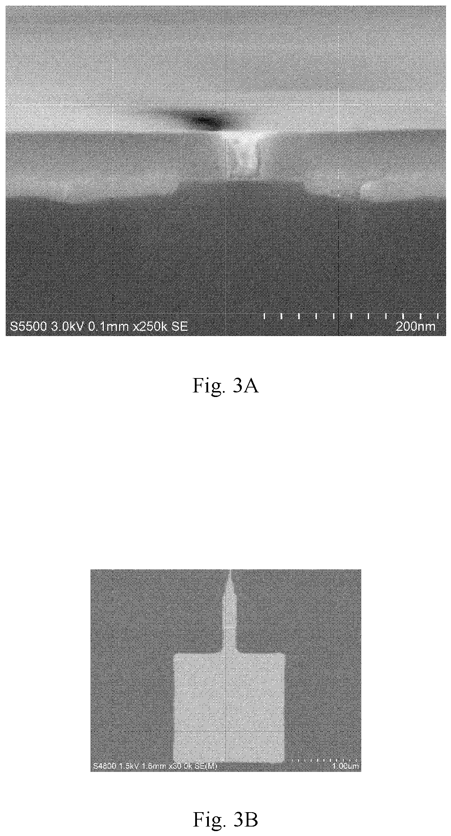

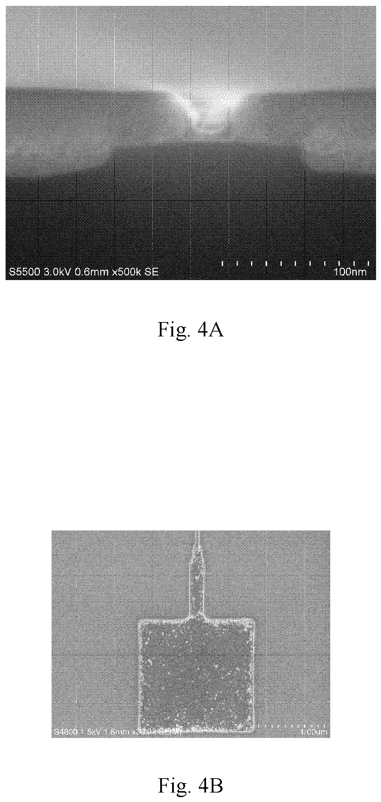

Fig. 3A and 3B are pictures which show a cross section view and a top view of a W layer manufactured according to an example method of the present disclosure, respectively. As a comparison, Fig. 4A and 4B are pictures which show a cross section view and a top view of a B₂H₆ base W layer manufactured according to a conventional method, respectively. It can be seen by comparing Fig. 3A and Fig. 4A that the W layer according to the embodiment of the present disclosure keeps good filling into the gate trench, and it can be seen by comparing Fig. 3B and Fig. 4B that the W layer according to the embodiment of the present disclosure has better adhesion (less cracks).

According to embodiments of the present disclosure, the resultant W layer has better adhesion and a good filling behavior, and applying it to a 22nm metal gate electrode may improve the yield and may extend the process window for filling.

The embodiments of the present disclosure are illustrated as mentioned above. However, these embodiments are provided for illustration and is not intended to limit the scope of the present disclosure which is defined by the accompanying claims and their equivalents. Without departing from the scope of the present disclosure, those skilled in the art may make any alternation or modification which falls in the scope of the appended claims.

## Claims

1. A method of depositing a Tungsten (W) layer, comprising:
pre-processing a substrate by depositing a SiH₄ base W film on a surface of the substrate by means of an Atomic Layer Deposition (ALD) process; and
depositing a B₂H₆ base W layer on the pre-processed surface by means of the ALD process,
wherein the ALD process comprises:
introducing a SiH₄ gas and a WF₆ gas to a reactive cavity to form the SiH₄ base W film; and
alternately introducing a B₂H₆ gas and a WF₆ gas into the reactive cavity for a number of cycles to form the B₂H₆ base W layer, **characterized in that** the substrate comprises a gate trench formed by a gate-last process, and the W film and the W layer fill into the gate trench to function as a gate electrode.

2. The method according to claim 1, wherein the SiH₄ base W film is formed on the surface of the substrate to a thickness of several atom layers.

3. The method according to claim 1, wherein the ALD process comprises a reactive source gas soak operation, a reactive source gas introduction operation, and a main deposition operation, wherein the SiH₄ gas and the WF₆ gas are introduced to the reactive cavity during the reactive source gas introduction operation, and the B₂H₆ gas and the WF₆ gas are introduced into the reactive cavity during the main deposition operation.

4. The method according to claim 3, wherein the reactive source gas soak operation comprises:
introducing a SiH₄ gas to the reactive cavity.

5. The method according to claim 3, wherein during the reactive source gas introduction operation, the SiH₄ gas and the WF₆ gas are alternately introduced into the reactive cavity for several cycles.

6. The method according to claim 5, wherein the number of the cycles is 2-10.

7. The method according to claim 1, wherein the number of the cycles depends on a thickness of the W layer to be deposited.

## Patentansprüche

1. Verfahren zum Abscheiden einer Wolframschicht (W), umfassend:
Vorverarbeiten eines Substrats durch Abscheiden eines SiH₄-basierten W-Films auf eine Oberfläche des Substrats mittels eines Atomlagenabscheidungs (ALD)-Prozesses; und
Abscheiden einer B₂H₆-basierten W-Schicht auf die vorverarbeitete Oberfläche mittels des ALD-Prozesses,
wobei der ALD-Prozess umfasst:
Einleiten eines SiH₄-Gases und eines WF₆-Gases in einen reaktiven Hohlraum, um den SiH₄-basierten W-Film zu bilden; und abwechselndes Einleiten eines B₂H₆-Gases und eines WF₆-Gases in den reaktiven Hohlraum für eine Anzahl von Zyklen, um die B₂H₆-basierte W-Schicht zu bilden,
**dadurch gekennzeichnet, dass**
das Substrat einen Gate-Trench umfasst, der durch einen Gate-Last-Prozess gebildet wird, und der W-Film und die W-Schicht den Gate-Trench füllen, um als Gateelektrode zu arbeiten.

2. Verfahren nach Anspruch 1, wobei der SiH₄-basierte W-Film auf der Oberfläche des Substrats bis zu einer Dicke von verschiedenen Atomschichten gebildet ist.

3. Verfahren nach Anspruch 1, wobei der ALD-Prozess einen reaktiven Quellgas-Einweichvorgang, einen reaktiven Quellgas-Einleitungsvorgang und einen Hauptabscheidungsvorgang umfasst, wobei das SiH₄-Gas und das WF₆-Gas während des reaktiven Quellgas-Einleitungsvorgangs in den reaktiven Hohlraum eingeleitet werden, und das B₂H₆-Gas und das WF₆-Gas während des Hauptabscheidungsvorgangs in den reaktiven Hohlraum eingeleitet werden.

4. Verfahren nach Anspruch 3, wobei der reaktive Quellgas-Einweichvorgang umfasst:
Einleiten eines SiH₄-Gases in den reaktiven Hohlraum.

5. Verfahren nach Anspruch 3, wobei während des reaktiven Quellgas-Einleitungsvorgangs das SiH₄-Gas und das WF₆-Gas in den reaktiven Hohlraum abwechselnd für verschiedene Zyklen eingeleitet wird.

6. Verfahren nach Anspruch 5, wobei die Anzahl der Zyklen 2-10 beträgt.

7. Verfahren nach Anspruch 1, wobei die Anzahl der Zyklen von einer Dicke der abzuscheidenden W-Schicht abhängt.

## Revendications

1. Procédé de dépôt d'une couche de tungstène (W), comprenant :
le prétraitement d'un substrat par dépôt d'un film de tungstène en utilisant un gaz SiH₄ sur une surface du substrat au moyen d'un procédé de dépôt par monocouches atomiques (ALD) ; et
le dépôt d'une couche de tungstène en utilisant un gaz B₂H₆ sur la surface prétraitée au moyen du procédé ALD,
le procédé ALD comprenant :
l'introduction d'un gaz SiH₄ et d'un gaz WF₆ dans une enceinte de réaction pour former le film de tungstène en utilisant un gaz SiH₄ ; et
l'introduction tour à tour d'un gaz B₂H₆ et d'un gaz WF₆ dans l'enceinte de réaction sur plusieurs cycles pour former la couche de tungstène en utilisant un gaz B₂H₆,
**caractérisé en ce que**
le substrat comprend une tranchée grille formée par un procédé « grille en dernier » (gate last), et le film de tungstène et la couche de tungstène remplissent la tranchée de grille pour fonctionner comme une électrode grille.

2. Procédé selon la revendication 1, dans lequel le film de tungstène formé en utilisant un gaz SiH₄ est formé sur la surface du substrat jusqu'à une épaisseur de plusieurs couches d'atomes.

3. Procédé selon la revendication 1, dans lequel le procédé ALD comprend une opération d'immersion dans un gaz source réactif, une opération d'introduction de gaz sources réactifs, et une opération principale de dépôt, dans lequel le gaz SiH₄ et le gaz WF₆ sont introduits dans l'enceinte de réaction durant l'opération d'introduction de gaz sources réactifs, et le gaz B₂H₆ et le gaz WF₆ sont introduits dans l'enceinte de réaction durant l'opération principale de dépôt.

4. Procédé selon la revendication 3, dans lequel l'opération d'immersion dans un gaz source réactif comprend :
l'introduction d'un gaz SiH₄ dans l'enceinte de réaction.

5. Procédé selon la revendication 3, dans lequel, durant l'opération d'introduction de gaz sources réactifs, le gaz SiH₄ et le gaz WF₆ sont introduits à tour de rôle dans l'enceinte de réaction sur plusieurs cycles.

6. Procédé selon la revendication 5, dans lequel le nombre de cycles est de 2 à 10.

7. Procédé selon la revendication 1, dans lequel le nombre des cycles dépend d'une épaisseur de la couche de tungstène à déposer.
